# FASCICULE DE BREVET EUROPEEN

(11) **EP 2 613 342 B1**
(45) Date de publication et mention de la délivrance du brevet: **20.11.2019**
(21) Numéro de dépôt: 13150308.8
(22) Date de dépôt: 04.01.2013
(51) Int. Cl.: H01L 21/28, H01L 29/423, H01L 29/66, H01L 29/792, H01L 29/78, H01L 27/115

(54) **Procédé de fabrication d'une cellule mémoire non volatile à double grille**
Verfahren zur Herstellung einer nicht-flüchtigen Speicherzelle mit Doppel-Gate
Method for manufacturing a double-gate non-volatile memory cell

(30) Priorité: 09.01.2012 FR 1250203
(43) Date de publication de la demande: 10.07.2013
(73) Titulaire: COMMISSARIAT À L'ÉNERGIE ATOMIQUE ET AUX ÉNERGIES ALTERNATIVES, 75015 Paris (FR)
(72) Inventeur: Charpin-Nicolle, Christelle, 38120 FONTANIL-CORNILLON (FR); Jalaguier, Eric, 38410 SAINT MARTIN D'URIAGE (FR)
(74) Mandataire: Hautier, Nicolas

(56) Documents cités:
- EP-A1- 2 381 471
- US-A1- 2007 228 498
- US-B2- 7 130 223

## Description

### DOMAINE TECHNIQUE DE L'INVENTION

L'invention concerne le domaine des dispositifs mémoires ou mémoires électroniques de type non-volatiles. Elle trouve pour application particulièrement avantageuse le domaine des mémoires électroniques de type Flash à double grille comprenant une grille de commande, également désignée grille du transistor de commande, et une grille de mémorisation, également désignée grille de contrôle du transistor de mémorisation.

### ÉTAT DE LA TECHNIQUE

Il existe plusieurs types de mémoires non-volatiles, c'est-à-dire des mémoires conservant une information stockée en l'absence d'alimentation électrique, et pouvant être écrites et/ou effacées électriquement :
- les EPROMs, de l'anglais «Erasable Programmable Read Only Memories» c'est-à-dire «mémoires mortes (à lecture seule) effaçables et programmables » dont le contenu peut être écrit électriquement, mais qui doivent être soumises à un rayonnement ultra violet (UV) pour effacer les informations qui y sont mémorisées.
- les EEPROMs, de l'anglais «Electrically Erasable Programmable ROMs » c'est-à-dire «mémoires mortes effaçables et programmables électriquement » dont le contenu peut donc être écrit et effacé électriquement, mais qui requièrent pour leur réalisation des surfaces de semi-conducteur plus importantes que les mémoires de type EPROM, et qui sont donc plus coûteuses à réaliser.
- les mémoires Flash. Ces mémoires non volatiles ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en terme de densité d'intégration et l'avantage des mémoires EEPROMs en terme d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, notamment les clés dites USB, de l'anglais «universal serial bus» qui sont capables de se connecter directement sur un « bus série universel » devenu un standard de la micro informatique, et bien d'autres applications. Les mémoires Flash ne possèdent pas d'éléments mécaniques, ce qui leur confère de plus une assez grande résistance aux chocs.

La plupart des mémoires Flash sont du type « stand-alone » c'est-à-dire qu'il s'agit de dispositifs autonomes présentant de grandes capacités de stockage, généralement supérieures à 1 gigabit ou Gb (1Gb = 10⁹ bits), et qui sont dédiées aux applications de stockage de masse.

Il existe également des mémoires Flash dites embarquées dont la réalisation est intégrée à celle d'un procédé, par exemple celui dit CMOS, acronyme de l'anglais « complementary metal oxide semiconductor », procédé technologique le plus largement utilisé par l'industrie de la microélectronique pour la réalisation de circuits intégrés à base de transistors « complémentaires » (C) de type « métal-oxyde-semiconducteur » (MOS). Ces mémoires trouvent un intérêt croissant, par exemple dans les domaines de l'automobile ou des microcontrôleurs, pour le stockage de données ou de codes. Ces mémoires Flash embarquées sont réalisées sur une puce qui comporte également des circuits CMOS destinés à réaliser des fonctions logiques autres qu'une mémorisation de données. Ces mémoires Flash embarquées sont généralement réalisées pour des capacités de stockage plus faibles que celles des mémoires de type «stand-alone», leur capacité pouvant varier généralement de quelques bits à quelques mégabits ou Mb (1 Mb = 10⁶ bits). Les caractéristiques visées des mémoires Flash embarquées sont un faible coût de réalisation, une excellente fiabilité (notamment à haute température), une faible consommation électrique, ou encore une vitesse de programmation élevée, ces caractéristiques étant fonction de l'application à laquelle elles sont destinées.

La plupart des points mémoires Flash ont une structure de type transistor MOS comprenant trois électrodes : source, drain et grille, cette dernière permettant de créer un canal de conduction entre source et drain. Leur particularité pour permettre la mémorisation non volatile d'une information est qu'elles comportent en outre un site de stockage de charges électriques, appelé grille flottante, formé par exemple d'une couche de silicium polycristallin disposée entre deux couches d'oxyde, placés entre le matériau électriquement conducteur de grille et le canal du transistor. La mémorisation est obtenue en appliquant sur le matériau conducteur une tension supérieure à la tension de seuil, par exemple comprise entre 15 volts et 20 volts, de façon à stocker l'information sous la forme de charges piégées par la grille flottante.

Cependant, de telles mémoires présentent des inconvénients limitant la réduction de leurs dimensions. En effet, une réduction de l'épaisseur de l'oxyde tunnel qui est disposé entre le canal et la couche de silicium polycristallin constituant la grille flottante, entraîne une augmentation du SILC, acronyme de l'anglais « stress induced leakage current » désignant le « courant de fuite induit par la tension ». L'utilisation prolongée d'une telle mémoire, c'est-à-dire la répétition de cycles d'écriture et d'effacement, génère à la longue des défauts dans l'oxyde tunnel qui tendent à évacuer les charges piégées dans la grille flottante. De même un SILC ou courant de fuite important affecte le temps de rétention des charges dans la grille flottante. Dans la pratique, il est donc difficile de réduire l'épaisseur de l'oxyde tunnel de ces mémoires à moins de 8 nanomètres ou nm (1nm = 10⁻⁹ mètre) sans que le SILC ne devienne un phénomène critique pour la mémorisation. De plus, en réduisant les dimensions d'une telle cellule mémoire, le couplage parasite entre les grilles flottantes de deux cellules adjacentes d'une même mémoire devient important et peut donc dégrader la fiabilité de la mémoire.

Pour ces raisons, des mémoires de type MONOS (Métal Oxyde Nitrure Oxyde Silicium), également appelées mémoires NROM, ont été proposées pour remplacer les mémoires à grille flottante en silicium polycristallin. Le document US 5 768 192 décrit de telles mémoires dans lesquelles les charges électriques sont stockées dans des pièges formés dans une grille flottante composée de nitrure et disposée entre deux couches d'oxyde. Dans une telle couche de nitrure, les pièges sont isolés les uns des autres. Ainsi, un électron stocké dans un des pièges reste localisé physiquement dans ce piège, ce qui rend ces mémoires beaucoup moins sensibles aux défauts dans l'oxyde tunnel, et donc moins impactées par une augmentation du SILC. En effet, en présence d'un défaut dans l'oxyde tunnel, la couche de mémorisation, c'est-à-dire la couche de nitrure, perd uniquement les électrons situés au voisinage du défaut, les autres électrons piégés n'étant pas affectés par ce défaut. Ces mémoires disposent donc d'une meilleure fiabilité. Il est ainsi possible d'avoir un oxyde tunnel d'épaisseur inférieure à environ 8 nm, et donc de réduire les tensions de programmation nécessaires. De plus, du fait de la faible épaisseur du nitrure pour former la couche de mémorisation, le couplage entre deux cellules mémoires adjacentes est fortement réduit par rapport à des cellules à grille flottante en silicium polycristallin. Enfin, la structure d'une mémoire de type NROM est également adaptée pour réaliser des mémoires embarquées en raison de la simplicité du procédé d'intégration de ces mémoires.

Le document de S. Kianian et coauteurs « A novel 3 volt-only, small sector erase, high density flash E²PROM", Technical Digest of VLSI Technology, 1994, p.71 », décrit un autre type de mémoire, appelée mémoire « split-gate », c'est-à-dire mémoire à « grille partagée » qui combine au sein d'une même cellule mémoire un transistor de mémorisation et un transistor de sélection (ou transistor de commande) formés sur une unique zone active. Une telle cellule mémoire à double grille est généralement programmée par injection de porteurs par la source, mécanisme qui requiert la présence d'un transistor de sélection accolé au transistor de mémorisation, et qui permet d'augmenter la vitesse de programmation tout en réduisant la consommation par rapport à une mémoire de type NROM.

Afin de bénéficier des avantages de chacune des structures ci-dessus, c'est-à-dire : split-gate et NROM, le document US 2004/207025 propose un autre type de mémoire à double grille combinant les deux structures. Une des difficultés pour réaliser ces mémoires concerne alors le contrôle de la position relative des grilles, c'est-à-dire la position de la grille du transistor de commande par rapport à la position de la grille de contrôle du transistor de mémorisation. En effet, ces grilles sont réalisées par deux photolithographies successives, le désalignement de la seconde grille par rapport à la première grille fixant la longueur de la seconde grille. Un mauvais contrôle des positions relatives des deux grilles se traduit donc par un mauvais contrôle des caractéristiques électriques du second transistor, et donc de mauvaises performances de la mémoire. Par conséquent, un contrôle très précis de la position des grilles est nécessaire lors de la réalisation de ce type de mémoire.

Afin de s'affranchir de cette contrainte d'alignement, le document US 7 130 223 propose également de réaliser une mémoire à double grille combinant la structure d'une mémoire de type NROM avec une architecture split-gate. Cependant, la grille de contrôle du transistor de mémorisation est dans ce cas réalisée sous la forme d'un espaceur latéral de la grille du transistor de commande, lequel est disposé contre un des deux flancs latéraux de la grille du transistor de commande. Une telle structure permet de contrôler précisément la position et la dimension de la grille de contrôle du transistor de mémorisation par rapport à la grille du transistor de commande. En effet, la grille de contrôle du transistor de mémorisation étant réalisée sous la forme d'un espaceur latéral de la grille du transistor de commande celle-ci se trouve être alors auto alignée sur cette dernière.

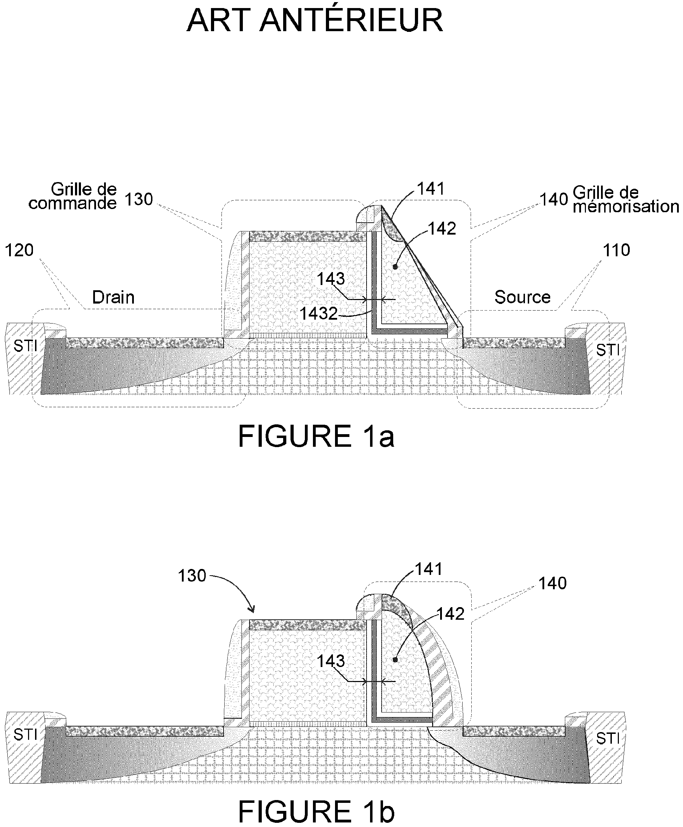

Toutefois, avec une telle structure, il est très difficile de réaliser ensuite une reprise de contact électrique sur la grille de contrôle du transistor de mémorisation compte tenu des faibles dimensions de cette grille en forme d'espaceur latéral. Ce problème est illustré sur la figure 1. La figure 1a montre une vue en coupe d'un exemple d'une telle cellule mémoire à double grille. Entre les zones source 110 et drain 120 on dispose les deux grilles partagées par une même cellule. Comme mentionné ci-dessus, la grille de contrôle 140 du transistor de mémorisation est réalisée, côté source 110, sous la forme d'un espaceur de la grille 130 du transistor de commande et est de ce fait auto alignée sur celle-ci. La grille 130 du transistor de commande, qui est comparable à celle d'un simple transistor de type MOS, peut être réalisée d'une façon traditionnelle par divers moyens et procédé connus de l'homme du métier. Sur la figure 1a on voit que la surface 141, qui permet d'établir un contact électrique avec la grille de contrôle 140 du transistor de mémorisation, est particulièrement limitée dans le cas d'un espaceur de forme triangulaire. Forme qui résulte le plus naturellement de la formation de l'espaceur avec les moyens et procédés connus de l'homme du métier. La surface de contact 141 correspond à la siliciuration du matériau sous-jacent qui est du silicium polycristallin 142 et qui constitue, en volume, l'essentiel du transistor de mémorisation. La mémorisation est typiquement obtenue à l'aide d'un empilement ou sandwich de couches 143 contenant une couche de piégeage de charges électriques. Cette couche de piégeage constitue la grille flottante qui sert à piéger les charges mémorisant l'état de la cellule mémoire dans la grille de contrôle du transistor de mémorisation comme décrit précédemment.

La figure 1b montre une vue en coupe d'un autre exemple d'une telle cellule mémoire à double grille où la surface de contact 141 de la grille de contrôle du transistor de mémorisation est agrandie en s'efforçant d'obtenir la forme la plus arrondie possible de l'espaceur. Ce type de forme est toutefois difficile à obtenir avec du silicium polycristallin 142, matériau qui constitue l'essentiel de la grille de contrôle du transistor de mémorisation.

La reprise de contact sur la grille de contrôle du transistor de mémorisation est très délicate à mettre en œuvre dans le cadre d'un processus industriel et demande notamment des spécifications de positionnement très contraignantes pour que les vias de connexions, en particulier ceux de connexion de la grille de contrôle du transistor de mémorisation, soient toujours bien positionnés. Un défaut de positionnement des vias empêcherait le fonctionnement de la cellule et pourrait en particulier créer un court circuit entre grille du transistor de commande et grille de contrôle du transistor de mémorisation.

Le document US2007/228498 décrit également une solution dans laquelle les électrodes de la grille du transistor de commande et de la grille de mémorisation sont adjacentes, cette solution présentant les inconvénients mentionnés précédemment.

Un objet de la présente invention est donc de proposer une nouvelle structure de cellule mémoire ou un nouveau procédé permettant de faciliter la reprise de contact de chacune des grilles et de limiter les risques de court-circuit.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de fabrication d'une cellule mémoire non volatile à double grille comprenant un transistor de commande comprenant une grille et un transistor de mémorisation comprenant une grille de contrôle adjacente à la grille du transistor de commande, dans lequel on effectue les étapes de:
∘ formation au moins partielle de la grille du transistor de commande comprenant l'obtention d'un relief en un matériau semi conducteur sur un substrat;
∘ formation de la grille de contrôle du transistor de mémorisation. La formation de la grille de contrôle comprend de préférence les étapes de: formation sur au moins un flanc du relief en un matériau semi conducteur et au moins une partie du substrat d'un empilement de couches configuré pour stocker des charges électriques; dépôt d'une première couche d'un matériau de préférence semi conducteur de manière à recouvrir l'empilement de couches au moins; gravure de la première couche de manière à former un premier motif de préférence juxtaposé au relief en un matériau semi conducteur de la grille du transistor de commande.

La formation de la grille de contrôle du transistor de mémorisation comprend en outre les étapes suivantes de: formation d'une deuxième couche en un matériau semi conducteur, au moins sur le premier motif ; gravure de la deuxième couche de sorte à former sur le premier motif un deuxième motif présentant une face supérieure sensiblement plane. Cette surface est adaptée pour permettre une reprise de contact sur la grille de contrôle du transistor de mémorisation.

La surface de contact de la grille de contrôle du transistor de mémorisation est donc significativement étendue. Le positionnement de la grille de contact par rapport à un via de connexion avec les couches de câblage supérieures est ainsi facilité. En outre, les risques de mauvais positionnement et les risques de court-circuit entre les grilles sont réduits.

Par ailleurs, le volume de matériau accessible et disponible par la suite pour effectuer une siliciuration est également augmenté ce qui permet d'améliorer la connexion électrique entre la grille du transistor de commande et les couches de câblage.

De manière facultative, l'invention peut en outre présenter au moins l'une quelconque des caractéristiques optionnelles suivantes :
- Le premier motif est situé sur le flanc du relief de la grille du transistor de commande et sur l'empilement de couches.
- Le premier motif présente une section sensiblement triangulaire. Alternativement, il présente une portion supérieure sensiblement arrondie. Le deuxième motif prolonge alors cette portion supérieure pour former une face sensiblement plane.
- Le relief en un matériau semi conducteur constitue la grille du transistor de commande. Il forme une ligne ou un rectangle. Si les flancs du relief en un matériau semi conducteur sont sensiblement perpendiculaires au substrat, alors le premier motif présente une section en forme de triangle rectangle dont les deux cotés opposés à l'hypoténuse sont respectivement tournés vers la grille du transistor de commande et vers le caisson d'isolement.
- Le deuxième motif présente une forme sensiblement parallélépipédique, un coté du parallélépipède formant la face supérieure sensiblement plane. La face est la face la plus éloignée du substrat.
- Les sections des premier et deuxième motifs sont prises selon un plan sensiblement perpendiculaire à la surface du substrat portant la cellule mémoire (ou surface sur laquelle est disposée la grille du transistor de commande).
- La grille de contrôle du transistor de mémorisation forme un espaceur pour la grille du transistor de commande.
- De préférence, la formation de l'empilement de couches comprend des étapes de dépôt effectuées sur l'ensemble de la plaque.
- Le dépôt de la première couche est effectué de manière à ce que la première couche recouvre un flanc au moins du relief en un matériau semi conducteur et se prolonge sur le substrat. De préférence, le dépôt de la première couche est effectué sur l'ensemble de la plaque. De préférence, la première couche est déposée directement sur l'empilement de couches.
- Avantageusement, le dépôt de la première couche est un dépôt conforme.
- Avantageusement, l'épaisseur du dépôt de la première couche est au moins égale au quart de l'épaisseur du relief en un matériau semi conducteur de la grille du transistor de commande. De préférence l'épaisseur du dépôt de la première couche est au moins égale à la moitié de l'épaisseur du relief en un matériau semi conducteur de la grille du transistor de commande. Encore plus préférentiellement, elle est environ égale à l'épaisseur du relief en un matériau semi conducteur de la grille du transistor de commande. Cette épaisseur relative permet de mieux contrôler la largeur finale de la grille de contrôle du transistor de mémorisation après gravure standard.
- De préférence le dépôt de la deuxième couche est effectué de manière à ce que la deuxième couche recouvre le premier motif et se prolonge sur le substrat.
- Préférentiellement, la formation de la deuxième couche consiste en un dépôt.
- Avantageusement, la formation de la deuxième couche est réalisée de manière à ce que son épaisseur soit constante sur toute la surface déposée. La formation de cette couche constitue donc un dépôt conforme.
- Avantageusement, l'épaisseur de la deuxième couche est adaptée pour ajuster la largeur de la face supérieure sensiblement plane dont on veut pouvoir disposer pour la reprise de contact en fonction d'un angle supérieur que forme le premier motif de section sensiblement triangulaire. L'angle supérieur est l'angle le plus éloigné du substrat. Il est ainsi relativement aisé de définir la surface qui servira à effectuer la reprise de contact.
- De préférence, l'épaisseur du dépôt de la deuxième couche est comprise entre un quart de et deux fois l'épaisseur du relief en un matériau semi conducteur de la grille du transistor de commande. Avantageusement, l'épaisseur du dépôt de la deuxième couche est comprise entre un tiers de et une fois l'épaisseur du relief en un matériau semi conducteur de la grille du transistor de commande. Encore plus avantageusement, l'épaisseur du dépôt de la deuxième couche est environ égale à la moitié de l'épaisseur du relief en un matériau semi conducteur de la grille du transistor de commande. On obtient ainsi une large surface permettant de faciliter la reprise de contact.
- Avantageusement, le procédé comprend au moins une séquence d'étapes effectuée à l'issue de la gravure de la deuxième couche. Chaque séquence comprend au moins le dépôt d'une couche additionnelle en un matériau similaire à celui de la deuxième couche puis une gravure anisotrope de cette couche additionnelle, la gravure étant dirigée de manière perpendiculaire au plan du substrat. Ainsi, on peut obtenir une surface supérieure plane et étendue même si la gravure anisotrope n'est pas parfaitement anisotrope. De préférence on ajuste l'épaisseur du dépôt de la couche additionnelle pour obtenir en fin de séquence une face supérieure présentant la surface souhaitée. Chaque séquence est de préférence effectuée avant l'étape de protection des motifs par une résine.
- Avantageusement, l'étape de formation au moins partielle de la grille du transistor de commande comprend, préalablement du dépôt de la première couche, la formation d'une couche sacrificielle également au dessus du relief en un matériau semi conducteur. Le procédé comprend également une étape de retrait de la couche sacrificielle, effectuée postérieurement à l'étape de gravure de la deuxième couche, de sorte à générer une différence de niveau entre la face supérieure du deuxième motif et l'extrémité supérieure du relief en un matériau semi conducteur. L'extrémité supérieure du relief en un matériau semi conducteur est la dimension la plus haute de la grille du transistor de commande prise selon une direction perpendiculaire au plan du substrat. Ainsi, la face supérieure est plus haute que l'extrémité du relief. Les risques de courts-circuits sont ainsi encore réduits.
- La formation de la grille de contrôle du transistor de mémorisation est effectuée de sorte que la grille de contrôle du transistor de mémorisation est auto alignée avec la grille du transistor de commande.
- Le matériau semi conducteur de la première couche est identique au matériau semi conducteur de la deuxième couche.
- De préférence, le relief en un matériau semi conducteur formant la grille du transistor de commande est en silicium. De préférence, il s'agit de silicium poly cristallin.
- De préférence, le matériau semi conducteur de la première couche est du silicium poly cristallin.
- De préférence, le matériau semi conducteur de la deuxième couche est du silicium poly cristallin. Le procédé selon l'invention est encore plus avantageux lorsque le matériau utilisé pour la grille de contrôle du transistor de mémorisation est du silicium poly cristallin. En effet avec ce type de matériau il est particulièrement difficile d'obtenir un premier motif présentant une forme supérieure arrondie.
- Avantageusement, la gravure de la première couche comprend : une première gravure anisotrope dirigée perpendiculairement à un plan du substrat. Cette gravure laisse en place une couche résiduelle moins épaisse sur les surfaces parallèles au plan du substrat que sur les surfaces inclinées par rapport au plan du substrat, c'est-à-dire typiquement sur les flancs du relief. La première gravure peut également faire disparaître la première couche sur les surfaces parallèles au plan du substrat. De préférence, à l'issue de la première gravure il subsiste une portion de la première couche sur les surfaces parallèles au plan du substrat et le procédé comprend une seconde gravure isotrope sélective qui enlève la couche résiduelle avec arrêt de la gravure sur ledit empilement de couches.
- Avantageusement, la gravure de la deuxième couche comprend : une première gravure anisotrope dirigée perpendiculairement au plan du substrat. Cette gravure laisse en place une couche résiduelle moins épaisse sur les surfaces parallèles au plan du substrat que sur les surfaces inclinées par rapport au plan du substrat, c'est-à-dire typiquement sur les flancs du premier motif. La deuxième gravure peut également faire disparaître la deuxième couche sur les surfaces parallèles au plan du substrat. De préférence, à l'issue de la deuxième gravure il subsiste une portion de la deuxième couche sur les surfaces parallèles au plan du substrat et le procédé comprend une seconde gravure isotrope sélective qui enlève la couche résiduelle avec arrêt de la gravure sur ledit empilement de couches. On contrôle ainsi parfaitement la fin de la gravure et l'épaisseur de chacune des couches déposées qui permettront de définir la surface de contact pour la connexion de la grille de contrôle du transistor de mémorisation.

Ainsi, la gravure de la première couche et/ou de la deuxième couche comprend, après la première gravure anisotrope, une deuxième gravure isotrope sélective avec arrêt de la gravure sur l'empilement de couches.
- La formation de l'empilement de couches est effectuée de sorte qu'il se prolonge sur le substrat. L'empilement de couches comprend deux couches d'isolant électrique enserrant une couche intermédiaire de piégeage de charges.
- Le procédé comprend une étape de recouvrement du deuxième motif par au moins une couche additionnelle d'oxyde à haute température, la couche de additionnelle d'oxyde à haute température étant selon une variante avantageuse recouverte d'une couche additionnelle de nitrure de silicium. Le procédé comprend en outre une étape de retrait partiel de la couche additionnelle de sorte à laisser libre en partie au moins la face supérieure sensiblement plane. De préférence, toute la face supérieure sensiblement plane est déprotégée.
- Le procédé comprend en outre une étape de siliciuration de la face supérieure sensiblement plane.

Un autre aspect de la présente invention concerne une cellule mémoire obtenue selon le procédé décrit ci-dessus.

Un autre aspect de la présente invention concerne une cellule mémoire non volatile à double grille comprenant un transistor de commande comprenant une grille et un transistor de mémorisation comprenant une grille de contrôle adjacente à la grille du transistor de commande, la grille du transistor de commande comprenant un relief en un matériau semi conducteur et la grille de contrôle du transistor de mémorisation comprenant :
- un empilement de couches juxtaposé à la grille du transistor de commande, se prolongeant sur une partie au moins du substrat et configuré pour stocker des charges électriques,
- un premier motif en un matériau semi conducteur disposé sur l'empilement de couches au moins et présentant une section sensiblement triangulaire.

En outre, la grille de contrôle du transistor de mémorisation comprend en outre un deuxième motif en un matériau semi conducteur disposé sur le premier motif et configuré pour présenter une face supérieure sensiblement plane.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1a 1b illustrent des cellules mémoires à double grille de l'art antérieur.
La FIGURE 2, qui comprend les figures 2a à 2e, décrit des étapes du procédé selon l'invention et qui permettent d'obtenir une reprise de contact beaucoup plus large sur la grille de contrôle du transistor de mémorisation d'une cellule mémoire à double grille.
La FIGURE 3, qui comprend les figures 3a à 3f, illustre des étapes additionnelles qui complètent la formation de la grille de contrôle du transistor de mémorisation d'une cellule mémoire à double grille.
La FIGURE 4, illustre une cellule mémoire à double grille selon un mode particulier de réalisation qui peut être optionnellement être obtenu en mettant en œuvre le procédé selon l'invention.

Les dessins joints sont donnés à titre d'exemples et ne sont pas limitatifs de l'invention.

### DESCRIPTION DÉTAILLÉE DE L'INVENTION

Il est rappelé que l'un des objectifs de l'invention est d'obtenir une zone de reprise de contact plus large qui permet de positionner facilement sur le transistor de mémorisation un via de connexion avec les couches de câblage supérieures.

Il est précisé que dans le cadre de la présente demande de brevet, le terme « sur » ne signifie pas obligatoirement « au contact de ». Ainsi par exemple, le dépôt d'une couche de poly silicium sur une couche d'isolant, ne signifie pas obligatoirement que la couche de poly silicium est directement au contact de la couche d'isolant mais cela signifie qu'elle la recouvre au moins partiellement en étant soit directement à son contact soit en étant séparé d'elle par une autre couche ou un autre élément.

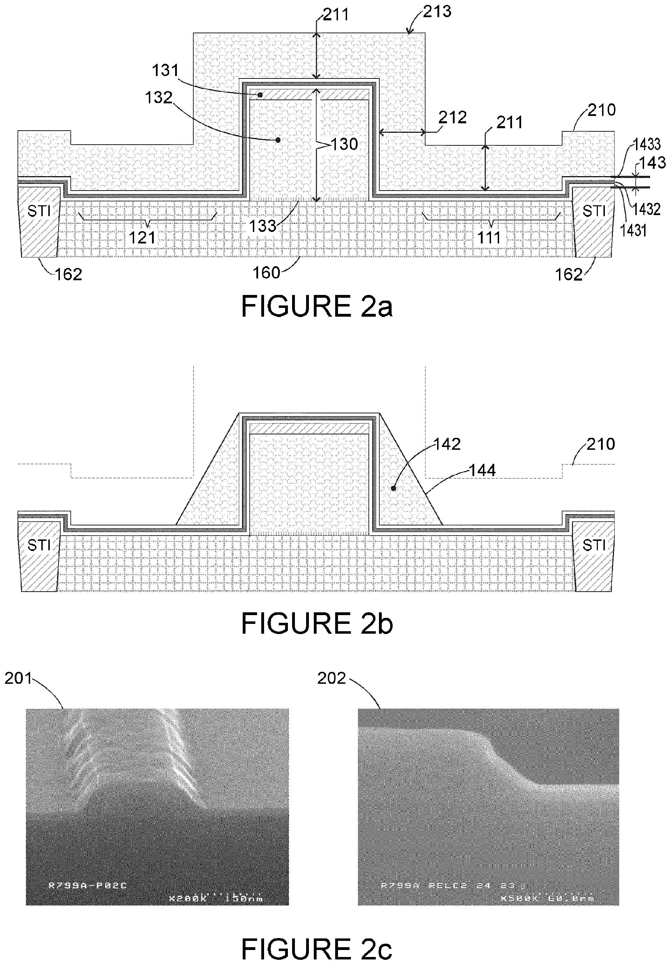

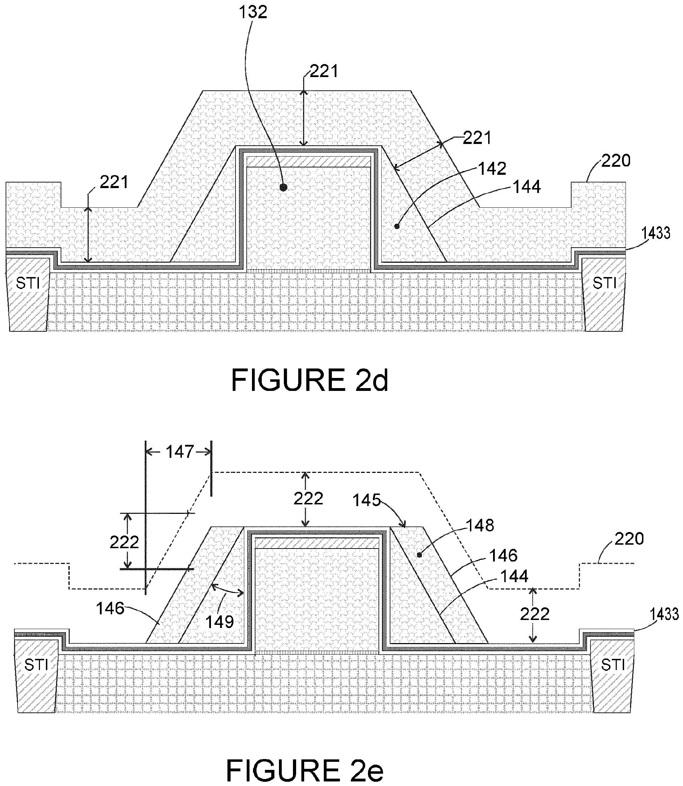

La **figure 2****,** qui comprend les figures 2a à 2e, illustre les étapes d'un exemple de procédé selon l'invention qui permet d'obtenir une surface de contact plus importante sur le transistor de mémorisation et plus précisément sur la grille de contrôle du transistor de mémorisation.

La **figure 2a** est une vue en coupe, similaire à celle de la figure 1a, d'une cellule mémoire à double grille à un stade du procédé de fabrication où l'on a déjà formé en partie au moins le transistor de commande et où l'on s'apprête à réaliser le transistor de mémorisation auto alignée, sans avoir recours à des opérations de lithographie. On rappelle que le transistor de commande et le transistor de mémorisation partagent la même source et le même drain. Ils sont donc compris dans une même cellule. Cette cellule est qualifiée habituellement de transistor double grille, chacune des grilles permettant d'assurer la fonction du transistor, soit de commande soit de mémorisation, auquel elle est dédiée. Jusqu'à ce stade, la fabrication d'une telle cellule mémoire se fait en utilisant les méthodes et moyens conventionnels mis en œuvre par l'industrie de la microélectronique notamment ceux pour la fabrication des transistors de type MOS. D'une façon standard ces transistors, comme les cellules mémoires à double grille de l'invention, sont fabriqués chacun dans un caisson 160 de silicium monocristallin. Les caissons sont électriquement isolés les uns des autre par des tranchées 162 typiquement en oxyde de silicium. La formation de ces tranchées fait appel à une technique dite STI, de l'anglais « shallow trench isolation », c'est-à-dire « isolation par tranchées peu profondes ». Les caissons 160 de silicium monocristallin sont en effet le plus souvent formés à partir de la mince couche superficielle de silicium monocristallin d'un substrat élaboré de type SOI, de l'anglais « silicon on insulator », c'est-à-dire un substrat « silicium sur isolant ». Cette couche de silicium monocristallin est elle-même placée au dessus d'une « couche d'oxyde enterrée » le plus souvent désignée par son acronyme BOX de l'anglais « buried oxide layer ». Chaque caisson se trouve être ainsi complètement isolé électriquement de ses voisins, latéralement et au fond, par de l'oxyde. N'étant pas nécessaire à la compréhension du procédé de l'invention, on notera que seule la couche superficielle et les tranchées latérales 162 dans laquelle les caissons 160 sont formés sont représentés. Par ailleurs, l'utilisation d'un substrat SOI est seulement un exemple particulier de mise en œuvre. D'autres moyens et méthodes peuvent être utilisés pour qu'une cellule mémoire à double grille, employant le procédé décrit ci-après, puisse être réalisée dans un caisson isolé 160 et qui serait obtenu autrement qu'à partir d'un substrat SOI.

La grille du transistor de commande, également désignée grille de commande, dont la géométrie a été définie par photolithographie comprend à ce stade plusieurs couches qui sont : un relief en matériau semiconducteur 132, de préférence en silicium polycristallin, assurant la fonction de grille; une couche d'oxyde 133 de la structure MOS sous laquelle, en fonction de la tension appliquée sur la grille du transistor de commande, on va créer un canal de conduction (non représenté) à la surface du caisson 160 entre les zones source 111 et drain 121, lesquels ne sont pas encore formés à ce stade ; optionnellement mais avantageusement une couche d'oxyde 131 qui sera enlevée, comme on le verra par la suite, pour avantageusement créer une différence de niveau pour la reprise de contact sur la grille de contrôle du transistor de mémorisation afin de prévenir un court circuit avec la grille de sélection. Cette couche d'oxyde 131 peut être qualifiée de couche sacrificielle. Source 111 et drain 121 seront obtenus généralement par implantation ionique d'un dopant de la couche de silicium monocristallin du caisson 160 d'isolement. La grille 130 du transistor de commande servant de masque, source et drain seront auto alignés sur celle-ci comme on le verra plus loin. Une première implantation ionique (non représentée) pourra être effectuée à ce stade afin de régler le seuil de conduction (VT) du transistor de mémorisation.

La figure 2a montre les couches qui sont déposées sur l'ensemble des dispositifs en cours de fabrication en vue de réaliser le transistor de mémorisation, c'est-à-dire à la surface d'une tranche d'un semi conducteur formant substrat. Après formation des grilles de commande 130, on dépose successivement les couches formant l'empilement ou sandwich de couches 143 contenant la couche de piégeage. Un exemple non limitatif de couche de piégeage est une couche désignée par son acronyme ONO, c'est-à-dire « oxyde nitrure oxyde» de silicium. La couche intérieure 1432 de nitrure de silicium (Si₃N₄) constitue la grille flottante qui sert à piéger les charges mémorisant l'état de la cellule mémoire dans le transistor de mémorisation comme décrit précédemment. D'autres structures sont possibles. Le sandwich comporte dans cet exemple trois couches : une première couche, désignée couche inférieure 1431, formant un isolant électrique, le plus souvent de l'oxyde de silicium ou SiO2 ; une deuxième couche, désignée couche intermédiaire ou couche de piégeage 1432, servant à piéger les charges destinées à mémoriser l'état de la cellule mémoire, il s'agit typiquement de nitrure de silicium ou Si₃N₄ ; une troisième couche, désignée couche supérieure 1433, formant également un isolant électrique, réalisée par exemple en oxyde de silicium comme pour la première couche.

Ensuite on dépose une première couche de silicium polycristallin 210. Cette couche est destinée à contribuer à la formation de la grille de contrôle 140 du transistor de mémorisation, également désignée grille de mémorisation. De préférence, la grille du transistor de commande est, comme on l'a vu ci-dessus, constituée aussi de silicium polycristallin qui a été déposé et gravé précédemment d'une façon conventionnelle. Le dépôt sera idéalement le plus « conforme » possible. Un dépôt est dit conforme quand les épaisseurs déposées sont les mêmes, indépendamment de l'angle d'inclinaison des surfaces sur lesquelles il est effectué. L'épaisseur est donc homogène en tout point de la surface recouverte, l'épaisseur étant mesurée selon une direction perpendiculaire à la surface libre de la couche. Un tel résultat peut être obtenu par exemple avec une méthode de dépôt entrant dans la catégorie de celles dites par LPCVD, acronyme de l'anglais « low pressure chemical vapor deposition », c'est-à-dire « déposition chimique en phase vapeur à faible pression ». On peut alors obtenir, comme représenté sur la figure 2a, une épaisseur horizontale 212 de dépôt sensiblement égale à l'épaisseur verticale 211.

Pour commencer à réaliser la grille de contrôle du transistor de mémorisation sous la forme d'un espaceur élargi de la grille du transistor de commande on pratique ensuite une gravure en deux étapes de la couche 210 de silicium polycristallin.
- Dans un premier temps on effectue une gravure très anisotrope de la couche 210, permettant d'abaisser de façon uniforme l'épaisseur de silicium polycristallin dans une direction privilégiée perpendiculaire au plan du substrat. Ce type de gravure peut être réalisé en utilisant les outils classiques de gravure disponibles en microélectronique. En particulier, en utilisant ceux procédant par bombardement physique à l'aide de gaz inertes de préférence à ceux utilisant des gaz réactifs induisant une réaction chimique. Cette première gravure doit permettre de maintenir la surface 213 de la couche de silicium polycristallin 210 située au dessus de l'empilement de couches de la grille 130 du transistor de commande la plus plate possible, c'est-à-dire, comme représenté idéalement sur les figures, en préservant des changements de niveaux les plus abrupts possibles. Dans le même temps, on fait diminuer l'épaisseur de silicium polycristallin en dehors de l'empilement de couches de la grille du transistor de commande. À l'issue de cette première étape de gravure on laisse typiquement une épaisseur 211 de silicium polycristallin au dessus de la grille du transistor de commande, et sur toutes les surfaces horizontales, c'est-à-dire celles parallèles au plan du substrat, de l'ordre de 5 à 10 nm.
- Dans un deuxième temps on effectue une gravure plutôt isotrope de ce qui reste de la couche 210 de silicium polycristallin. L'avantage est qu'avec ce type de gravure on peut obtenir une très bonne sélectivité entre gravure du silicium polycristallin et gravure de la couche d'isolant 1433 (oxyde de silicium) sous jacente. C'est sur cette dernière couche que le dépôt de silicium polycristallin a été effectué pour former la couche 210. On pourra alors aisément arrêter la gravure isotrope du silicium polycristallin sur cette couche d'isolant.

La **figure 2b** montre le résultat des deux étapes de gravure précédentes. Comme déjà discuté dans le chapitre sur l'état de la technique, il est extrêmement difficile d'obtenir une forme d'espaceur arrondie qui serait plus favorable pour une reprise de contact sur la grille de contrôle du transistor de mémorisation. Après les gravures décrites ci-dessus, on obtient plutôt un motif 144 de forme triangulaire pour ce qui reste, sur les flancs de la grille du transistor de commande, du silicium polycristallin 142 provenant de la couche 210. Cette forme triangulaire est obtenue quelle que soit l'épaisseur déposée initialement pour former cette couche en utilisant les procédés classiquement utilisés en microélectronique. De préférence on dépose une couche 210 d'épaisseur sensiblement égale à celle de la couche de silicium polycristallin 132 qui a servi à former la grille du transistor de commande. La forme triangulaire du motif 144 résulte essentiellement de ce que les gravures ne sont jamais parfaitement anisotropes ou parfaitement isotropes et de ce que les angles aux changements de niveaux sont toujours attaqués préférentiellement.

La **figure 2c** illustre avec des photos faites avec un microscope électronique à balayage (MEB) la forme triangulaire obtenue indépendamment de l'épaisseur de la couche de silicium déposée. La photo 201 montre le résultat obtenu avec une couche 210 déposée d'une épaisseur de 65 nm. La photo 202 montre le cas d'une épaisseur déposée double soit 130 nm.

La **figure 2d** illustre une étape additionnelle consistant à former une deuxième couche 220 au dessus de la grille 130 du transistor de commande et des motifs 142 formés par la première couche 210 déjà en place.

De préférence, cette deuxième couche 220 est obtenue par dépôt conforme de silicium polycristallin. Elle est destinée à élargir l'espaceur formant grille de contrôle de mémorisation. L'épaisseur 221 de cette deuxième couche 220 est ajustée en fonction de la largeur finale de l'espaceur que l'on veut obtenir comme on va le voir sur les figures suivantes. Le dépôt étant conforme : l'épaisseur 221 déposée est la même sur toute les surfaces quelle que soit leur inclinaison. Avant de procéder au dépôt de la deuxième couche 220 on effectue un nettoyage à l'acide fluorhydrique (FH) afin d'enlever la couche oxydée qui s'est formée spontanément en présence d'air sur le motif triangulaire 144 fait de silicium polycristallin 142 provenant du premier dépôt. Par exemple, l'épaisseur 221 de la deuxième couche 220 de silicium polycristallin est environ la moitié de celle 211 du premier dépôt 210.

La **figure 2e** montre le résultat de la gravure de la deuxième couche 220 de silicium polycristallin qui a été déposée comme décrit dans la figure précédente. La gravure se fait en deux étapes d'une façon identique à ce qui a été décrit pour la gravure de la couche 210 correspondant au premier dépôt de silicium polycristallin servant à former la grille de contrôle du transistor de mémorisation. Une première gravure anisotrope est donc réalisée dans une direction perpendiculaire au plan du substrat. Cette première gravure est suivie d'une gravure plus isotrope voire isotrope qui est, comme l'a vu, sélective vis-à-vis de la couche supérieure 1433 formant isolant et constituée dans cet exemple par un oxyde de silicium. Cela permet d'arrêter la gravure sur la couche supérieure 1433 d'isolant immédiatement sous jacente de l'empilement 143 de couches ONO.

Après gravure il reste, de la deuxième couche 220 correspondant au second dépôt, le motif 146, de préférence fait de silicium polycristallin 148, qui contribue à élargir sensiblement la grille de contrôle du transistor de mémorisation. Le procédé est configuré de sorte que ce motif 146 présente une face supérieure 145 la plus plane possible, ce qui va faciliter grandement la reprise de contact sur cette électrode.

La gravure 222 de la deuxième couche 220 étant essentiellement anisotrope elle se fait verticalement, c'est-à-dire perpendiculairement au plan du substrat. L'épaisseur à graver étant alors plus élevée dans la zone inclinée 147 correspondant à l'hypoténuse du motif triangulaire 144, il reste après gravure le motif 146 de part et d'autre de la grille du transistor de commande.

Connaissant l'angle 149 que forme l'hypoténuse du motif 144 avec la verticale, on peut estimer aisément la largeur de la face plane supérieure 145 du motif 146 que l'on va obtenir en faisant l'hypothèse simplificatrice que la gravure est totalement anisotrope et se fait à partir d'un dépôt parfaitement conforme d'épaisseur 221. On peut donc aussi déterminer l'épaisseur 221 de la deuxième couche 220 qu'il faut déposer pour obtenir une largeur donnée de la face 145 et ainsi ajuster la largeur totale de la grille de contrôle du transistor de mémorisation.

Typiquement, pour déterminer l'épaisseur à graver au niveau d'un flanc du relief de silicium polycristallin on peut effectuer le calcul suivant, basé sur la forme du motif 144. Le motif est obtenu après la première gravure et présente une section correspondant sensiblement à celle d'un triangle rectangle: L'épaisseur à graver 222 est donc égale à l'épaisseur du dépôt de la deuxième couche 220 divisée par la valeur du sinus de l'angle 149.

Par exemple, avec un angle 149 de 45° on trouve que la largeur de la face plane supérieure 145 obtenue correspond à l'épaisseur 221 du second dépôt de silicium polycristallin multipliée par un coefficient égal dans ce cas à 0,5, c'est-à-dire cosinus 45° Ceci pour les conditions idéales mentionnées ci-dessus : un dépôt de la deuxième couche 220 parfaitement conforme et une gravure complètement anisotrope. On peut bien sûr généraliser ce calcul à n'importe quel angle 149. D'un point de vue pratique on notera simplement ici que, quel que soit le coefficient de multiplication observé, la largeur de la face plane supérieure 145 augmente avec l'épaisseur 211. Elle peut donc être ajustée au mieux pour l'application considérée en contrôlant l'épaisseur du dépôt de la deuxième couche 220 servant à former la grille de contrôle du transistor de mémorisation. Ce résultat est à comparer au motif triangulaire 144 obtenu après gravure du dépôt de la première couche dont on a vu, dans les figures 2c et 2d, qu'il ne variait pas quand on augmentait l'épaisseur de cette première couche.

Il se peut qu'en pratique la face supérieure 145 du deuxième motif 146 ne soit pas parfaitement plane ou que sa largeur soit plus faible que prévue. Ceci est du au fait que la gravure est rarement parfaitement anisotrope. Selon un mode de réalisation avantageux de l'invention, on effectue alors au moins une séquence d'étapes, la séquence comprenant au moins les étapes suivantes: le dépôt d'une couche additionnelle en un matériau similaire à celui de la deuxième couche 220 puis une gravure anisotrope de cette couche additionnelle. En début de séquence, on ajuste l'épaisseur du dépôt de la couche additionnelle pour obtenir en fin de séquence une face supérieure 145 présentant la surface souhaitée.

Préférentiellement, chaque séquence comprend une étape de nettoyage avant l'étape de dépôt de la couche additionnelle.

Dans un mode de réalisation le procédé comprend une seule séquence. Dans un autre mode de réalisation, en particulier pour obtenir une surface 145 étendue, le procédé comprend deux séquences ou plus.

Ces séquences sont de préférence effectuées entre les étapes référencées 2e et 3a sur les figures. Chaque séquence est de préférence effectuée avant l'étape de protection des motifs par une résine.

En jouant sur l'épaisseur du dépôt de la deuxième couche 220 ainsi que sur des séquences optionnelles de dépôt et gravure de couches additionnelles dont les épaisseurs de dépôts auront été soigneusement contrôlées, l'invention permet d'obtenir une face supérieure 145 dont la planéité et la surface est précisément maîtrisée.

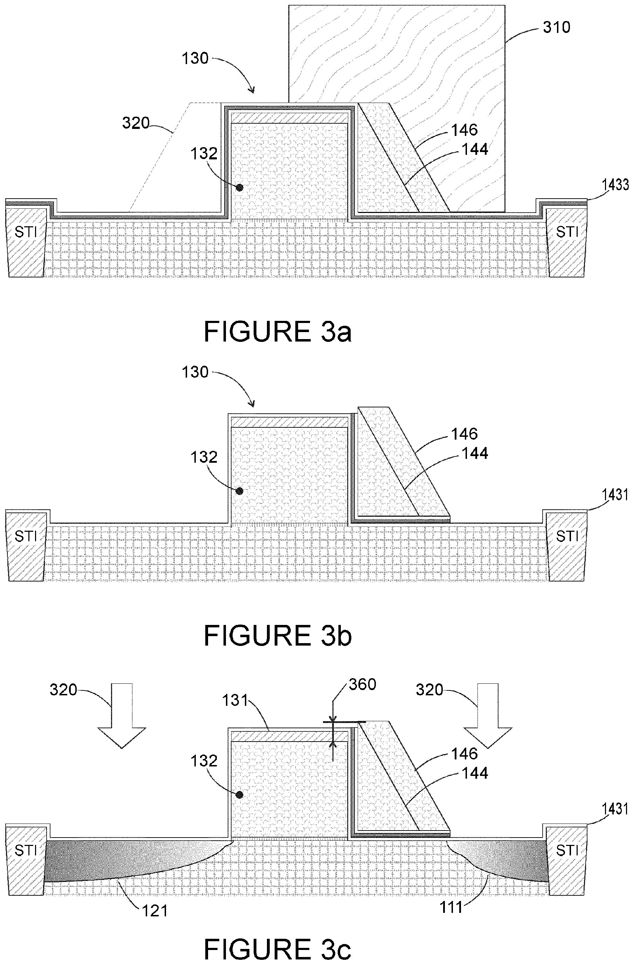

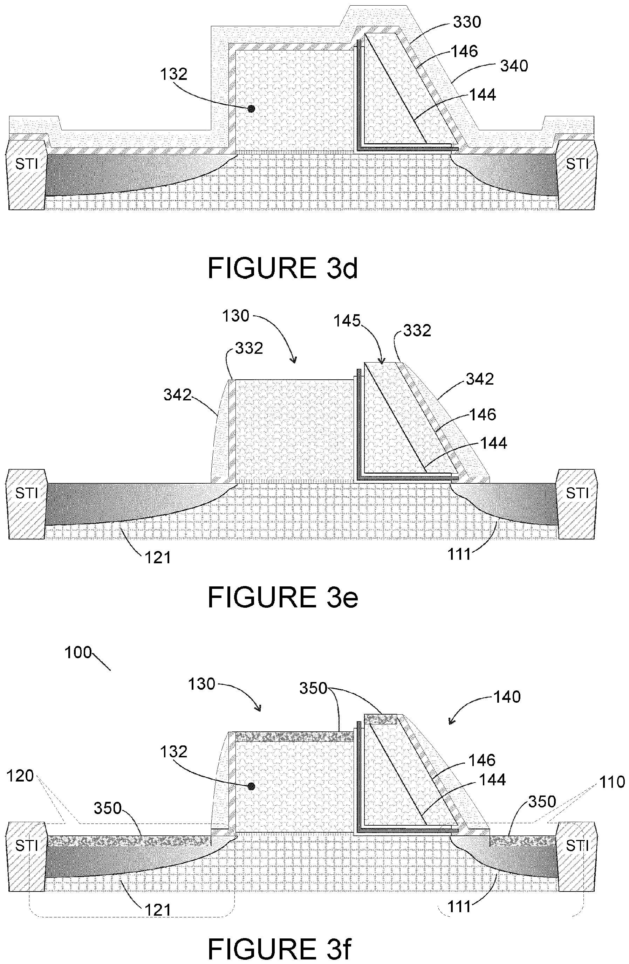

La **figure 3**, qui comprend les figures 3a à 3f, décrit les étapes suivantes du procédé de formation de la grille de contrôle du transistor de mémorisation. Ces étapes permettent de finaliser la structure de la cellule mémoire présentant une surface de reprise de contact beaucoup plus large en raison de l'application préalable des étapes décrites en référence aux figures précédentes.

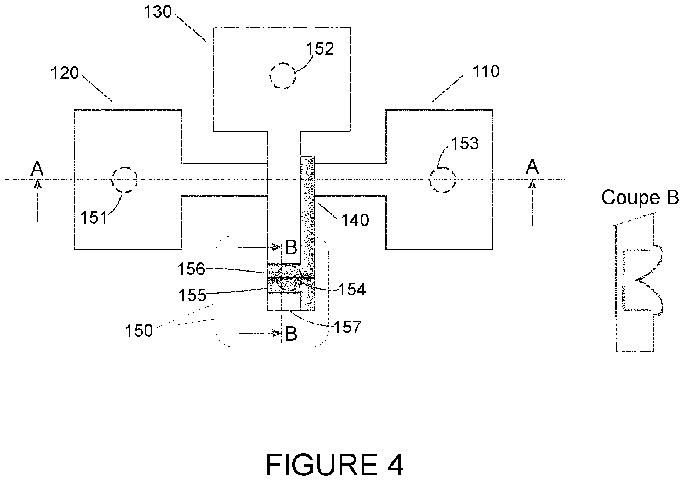

La **figure 3a** illustre l'étape où on délimite la zone du transistor de mémorisation 140 qui va être gardée. Comme illustré sur la figure 4 qui sera décrite en détail par la suite, cette figure étant est une vue en plan d'un exemple non limitatif de cellule mémoire, on ne laisse subsister par photogravure qu'une partie de l'espaceur créé avec les deux couches de silicium polycristallin, 210 et 220, comme expliqué dans les figures 2a à 2e. Cet espaceur a été créé, sans lithographie, tout autour de la grille du transistor de commande et on ne le laisse que sur un des flancs de cette dernière pour y former la grille de contrôle 140 du transistor de mémorisation. Optionnellement, on peut créer une zone de reprise 150 plus large, par exemple dans le prolongement de la grille 130 du transistor de commande comme illustré et décrit en référence à la figure 4. La figure 3a montre, en coupe, la couche de résine photosensible utilisée par l'opération de photolithographie correspondante après révélation des motifs. Les motifs 310 de résine protègent la partie de l'espaceur, constitué des motifs 144 et 146, qui doit rester en place.

A ce stade on procède, dans les zones non protégées 320 par les motifs 310 de résine, à une gravure sèche des motifs issus des deux couches 210 et 220 qui ont été déposées pour former l'espaceur. La gravure des deux couches supérieures de l'empilement 143 de couches ONO est alors réalisée avec arrêt dans la couche inférieure 1431. La **figure 3b** illustre cette étape où l'on procède également à l'enlèvement de la résine. On grave successivement la couche supérieure d'isolant 1433 (oxyde de silicium dans cet exemple), puis la couche intermédiaire 1432 (nitrure de silicium dans cet exemple). La gravure se fait sur toute la surface des dispositifs en cours de fabrication. Le sandwich 143 de couches ONO est protégé de l'attaque dans le transistor de mémorisation par les motifs 144 et 146 (motifs de silicium polycristallin dans cet exemple). La figure 3b est une vue en coupe à l'issue de cette gravure. Il ne reste donc en place à ce stade que la couche inférieure d'isolant 1431 (oxyde de silicium dans cet exemple) de la couche ONO qui sert d'arrêt à la gravure ci-dessus. Une gravure dite « sèche » est une gravure de type RIE, acronyme de l'anglais « reactive ion etching », c'est-à-dire « gravure ionique réactive » ou « gravure par ions réactifs ». Dans cette technique le plasma réagit non seulement physiquement mais aussi chimiquement avec la surface d'une tranche qui y est exposé en retirant une partie ou certaines des substances qui y ont été déposées préalablement. Le plasma est généré sous basse pression, de 10⁻² à 10⁻¹ torr, par un ou plusieurs champs électriques voire magnétiques. Les ions de haute énergie du plasma attaquent la surface de la tranche en réagissant avec celle-ci.

On notera ici que l'empilement de couches ONO 143 n'est qu'un exemple typique de mise en œuvre de la couche de piégeage nécessaire à la réalisation du transistor de mémorisation qui est souvent aussi désignée par le terme générique « interpoly ».

La **figure 3c** illustre l'étape où l'on procède au dopage des zones source 121 et drain 111. Au cours de cette étape on procède, préalablement à l'opération d'implantation ionique 320 destinée à doper les zones source et drain, à une gravure humide de la couche 1431, restant de l'empilement de couches 143, et au dépôt d'une couche d'un oxyde dit « écran » par exemple d'une épaisseur de 3 nm. Cette couche écran, non représentée, est destinée à protéger le silicium sous-jacent lors de l'implantation ionique 320 formant source et drain.

Typiquement, on procède ensuite à un recuit des dopants implantés, à un retrait de l'oxyde écran et à une désoxydation de la couche sacrificielle 131, encore appelée masque dur, toujours présente sur la grille du transistor de commande. L'enlèvement de la couche sacrificielle 131 permet avantageusement de créer un décrochage 360 entre le silicium polycristallin 132 de la grille du transistor de commande et celui de la grille de contrôle du transistor de mémorisation, formé des motifs 144 et 146. Cette différence de niveau ainsi créée permet de minimiser les risques de court-circuit entre ces deux électrodes.

Les **figures 3d** et **3e** illustrent la réalisation des espaceurs après que la couche inférieure 1431 de l'empilement de couches 143 ONO a été enlevée ainsi que la couche d'oxyde sacrificielle 131 qui sert à créer, comme on vient de le voir, une dénivellation entre le haut de la grille du transistor de commande et le haut de celle de mémorisation 140 pour minimiser les risques de court-circuit. De préférence, la couche sacrificielle 131 est disposée entre le relief 132 de silicium polycristallin et l'empilement de couches 143. De préférence, l'épaisseur de la couche sacrificielle est comprise entre 1/5 et 1/3 l'épaisseur de la couche de silicium polycristallin formant la grille du transistor de commande. De préférence, l'épaisseur de la couche sacrificielle est comprise entre quelques nanomètres et quelques dizaines de nanomètres. Elle permet ainsi de positionner l'extrémité supérieure du relief 132 de silicium polycristallin à un niveau inférieur à la face supérieure 145 du deuxième motif 146. Les risques de mauvaises connexions avec les interconnexions sont ainsi significativement limités et les risques de courts-circuits réduits.

On procède ensuite au dépôt d'une couche 330. Selon un exemple avantageux, cette couche est un oxyde dit HTO, de l'anglais « high temperature oxide », c'est-à-dire « oxyde à haute température » obtenu par la technique LPCVD déjà mentionnée précédemment. Typiquement, une épaisseur de 10 nm est déposée. En tout état de cause cette épaisseur doit être suffisante pour combler les vides résultant de la gravure isotrope des couches d'oxyde de l'empilement 143 de couches ONO intervenue précédemment. Cette couche va servir de couche d'accrochage et de couche d'arrêt à la gravure lors de la formation qui suit des espaceurs de grille.

Comme montré sur la figure 3d le dépôt de la couche 330 est suivi d'un dépôt d'une couche 340, par exemple de nitrure de silicium (Si3N4). Ce dépôt peut être réalisé par la même technique que ci-dessus de dépôt chimique en phase vapeur à basse pression (LPCVD). On dépose une couche de nitrure de silicium qui est typiquement comprise dans une gamme d'épaisseur allant de 20 à 40 nm et qui va servir d'espaceur de grilles pour les opérations suivantes d'implantation et de siliciuration des contacts.

La **figure 3e** montre le résultat de la gravure des couches ci-dessus, c'est-à-dire : la couche 330 de HTO et la couche 340 de Si3N4. D'une façon conventionnelle, la gravure de ces couches est dans un premier temps très anisotrope afin de laisser en place sur les flans des grilles de commande et de mémorisation les motifs 332, en HTO, et les motifs 342 en Si3N4 qui servent d'espaceurs de grilles pour l'opération de siliciuration suivante. Cette gravure très anisotrope est suivie d'une gravure plus isotrope afin, comme décrit précédemment, d'être sélectif et permettre l'arrêt de la gravure sur le silicium polycristallin des grilles de commande et de mémorisation. Cette seconde gravure doit être suffisante pour dégager le haut 145 du motif 146 servant de reprise de contact sur la grille de contrôle du transistor de mémorisation et le haut de la grille du transistor de commande qui vont être siliciurés pour assurer un bon contact électrique.

Typiquement, à ce stade, on procède aussi à une seconde implantation des électrodes de source 111 et drain 121 afin d'en diminuer la résistance électrique. Cette seconde implantation est auto limitée par les espaceurs de grilles que l'on vient de réaliser.

La **figure 3f** montre les zones 350 qui sont ensuite siliciurées afin d'obtenir un meilleur contact électrique avec les vias, montrés en figure 4, qui donnent accès aux électrodes de la cellule mémoire à double grille : grille 130 du transistor de commande et grille de contrôle 140 du transistor de mémorisation ainsi que source et drain. Comme la seconde implantation ci-dessus, la siliciuration des contacts est auto limitée par les espaceurs de grilles.

Un avantage supplémentaire de la présente invention réside dans le fait que le volume de matériau semi conducteur accessible pour effectuer l'étape de siliciuration est augmenté par rapport aux procédés connus. Le volume de zones siliciurés est donc augmenté et le contact électrique est amélioré.

Cette opération complète la formation des électrodes et éléments actifs des cellules mémoire non volatiles à double grille 100 pouvant bénéficier du procédé de l'invention. Les opérations suivantes concernent la formation de toutes les interconnexions entre les composants et cellules mémoire d'un dispositif, celles dites de « fin de ligne » ou BEOL de l'anglais « back end of line », qui peuvent être effectuées d'une façon standard.

La **figure 4** illustre une vue en plan d'un exemple particulier et non limitatif de l'invention d'une cellule mémoire à double grille. Cette vue en plan montre les quatre électrodes contrôlant le point mémoire. On notera ici que les figures 1a et 1b sont des vues selon la coupe A de la cellule mémoire à une échelle toutefois différente. Cette vue fait apparaître notamment la source 110, le drain 120 et la grille 130 du transistor de commande. La source 110, le drain 120 et la grille 130 du transistor de commande sont formés par lithographie. On peut ménager, comme représenté, de larges surfaces de connexion destinées à recevoir des connexions verticales, c'est à dire les vias 151, 152 et 153, qui assurent les interconnexions avec les couches de câblage horizontales (non représentées) du dispositif contenant de telles cellules mémoires. La cellule comprend également une grille de contrôle 140 du transistor de mémorisation. La grille de contrôle 140 du transistor de mémorisation est formée, sans avoir recours à la lithographie, comme un espaceur sur un des flancs de la grille 130 du transistor de commande. La surface de connexion est comme déjà vu ci-dessus beaucoup plus réduite. Une amélioration apportée par cette structure particulière de cellule mémoire par rapport aux structures conventionnelles consiste à sensiblement doubler cette surface de contact en créant une zone 150 de reprise de contact électrique située, dans cet exemple, dans le prolongement de la grille 130 du transistor de commande. On s'arrange alors pour laisser dans cette zone, entre l'extrémité de la grille 130 du transistor de commande et un motif ou bloc 157 séparé, préférentiellement de même largeur et de même composition que la grille 130 du transistor de commande, deux espaceurs à une distance telle qu'ils seront en contact comme schématisé sur la coupe B. C'est dans cette région qu'un via 154 pourra assurer un contact électrique avec la grille 130 du transistor de commande. En pratique, une telle zone de reprise de contact n'est pleinement utile que si l'on sait obtenir en même temps une forme arrondie ou plane de l'espaceur comme dans l'exemple de la figure 1b.

De manière générale la cellule mémoire dont un exemple particulier est représenté en figure 4 peut présenter les caractéristiques suivantes. Elle comprend au moins :
- une zone active formée dans une couche de semi-conducteur et comportant un canal disposé entre une source 110 et un drain 120,
- une première grille disposée au moins sur une partie du canal,
- au moins une portion 155 d'un premier espaceur latéral disposé contre au moins un flanc latéral de la première grille, dont une partie forme une seconde grille disposée sur au moins une seconde partie du canal. L'une de la première ou de la seconde grille comportant en outre un empilement de couches 143 dont au moins une desdites couches est apte à stocker des charges électriques. De préférence, la première grille forme la grille 130 du transistor de commande et la seconde grille forme la grille de contrôle 140 du transistor de mémorisation.

De préférence, la cellule mémoire comporte en outre au moins une portion d'un deuxième espaceur latéral disposé contre au moins un flanc latéral d'un bloc 157 disposé sur la couche de semi-conducteur, le deuxième espaceur latéral étant en contact avec le premier espaceur latéral, les deux espaceurs latéraux étant composés de matériaux similaires, ladite portion du second espaceur latéral formant au moins une partie d'un plot de contact.

De manière optionnelle, dans cette exemple, une portion 156 est reliée électriquement à la seconde grille. Cette portion 156 est disposée contre deux flancs latéraux de la première grille distincts et perpendiculaires l'un par rapport à l'autre. Le plot de contact électrique, ou surface de reprise de contact, est ici formé par cette portion d'espaceur 156 et la portion d'espaceur 155 formée contre le bloc 157, et est disposé dans le prolongement de la première grille. Une telle variante de réalisation a notamment pour avantage de pouvoir rapprocher les lignes électriquement conductrices destinées à être réalisées pour contacter la première grille et la seconde grille, permettant ainsi d'augmenter la densité d'un dispositif mémoire formé d'une matrice de cellules mémoires.

Cette structure de cellule mémoire électronique à double grille permet de réaliser une reprise de contact électrique de chacune des grilles avec un risque de court-circuit réduit entre les grilles. Cette structure permet de relâcher quelque peu les contraintes liées à l'alignement des contacts électriques par rapport aux grilles de la cellule mémoire, et cela sans avoir à mettre en œuvre un niveau de photolithographie supplémentaire dédié à cette reprise de contact électrique.

Cependant il s'est avéré qu'en pratique, la reprise de contact pour ce type de cellule n'est réellement facilitée et les risques de courts circuits significativement réduits que si l'on parvient à obtenir une forme arrondie ou sensiblement plane de l'espaceur comme dans l'exemple de la figure 1b.

Le procédé selon l'invention et dont un exemple particulier est décrit en référence aux figures 2a à 3f permet d'obtenir ce type de forme. L'invention permet donc de faciliter considérablement la reprise de contact et ceci pour des structures variées de cellules mémoire, la structure décrite ci-dessus et dont un exemple est illustré en figure 4 n'étant pas limitative de l'invention. Le procédé selon la présente invention, appliqué à une cellule mémoire présentant une structure telle que décrite aux paragraphes faisant référence à la figure 4, permet d'atteindre des résultats particulièrement avantageux.

L'invention n'est pas limitée aux seuls exemples de réalisation précédemment décrits et s'étend à tous les modes de réalisation entrant dans la portée des revendications.

Notamment, l'invention ne se limite pas à une couche 210 de silicium polycristallin et/ou à une couche 220 de silicium polycristallin. Ces couches pourront également être constituées de tout autre matériau semi-conducteur ou d'un empilement de couches comprenant un matériau semi-conducteur.

Au vu de la description qui précède, il apparaît ainsi clairement que la présente invention permet l'obtention d'un cellule mémoire électronique à double grille permettant de réaliser une reprise de contact électrique de chacune des grilles ne nécessitant pas un alignement très précis des contacts électriques par rapport aux grilles et en limitant le risque de court-circuit entre ces dernières.

## Revendications

1. Procédé de fabrication d'une cellule mémoire non volatile à double grille (100) comprenant un transistor de commande comprenant une grille (130) et un transistor de mémorisation comprenant une grille de contrôle (140) adjacente à la grille (130) du transistor de commande, dans lequel on effectue les étapes de:
∘ formation au moins partielle de la grille (130) du transistor de commande comprenant l'obtention d'un relief (132) en un matériau semi conducteur sur un substrat (160, 162);
∘ formation de la grille de contrôle (140) du transistor de mémorisation, comprenant les étapes de:
- formation sur au moins un flanc du relief (132) en un matériau semi conducteur et au moins une partie du substrat (160, 162) d'un empilement de couches (143) configuré pour stocker des charges électriques;
- dépôt d'une première couche (210) d'un matériau semi conducteur de manière à recouvrir l'empilement de couches (143) au moins;
- gravure de la première couche (210) de manière à former un premier motif (144) juxtaposé au relief (132) en un matériau semi conducteur de la grille (130) du transistor de commande;
**caractérisé en ce que** la formation de la grille de contrôle (140) du transistor de mémorisation comprend en outre les étapes suivantes de:
∘ formation d'une deuxième couche (220) d'un matériau semi conducteur au moins sur le premier motif (144),
∘ gravure de la deuxième couche (220) de sorte à former sur le premier motif (144) un deuxième motif (146) présentant une face supérieure (145) sensiblement plane configurée pour permettre une reprise de contact sur la grille de contrôle (140) du transistor de mémorisation.

2. Procédé selon la revendication précédente dans lequel la section du premier motif (144) présente sensiblement une forme de triangle dont deux cotés adjacents sont respectivement tournés vers la grille du transistor de commande et vers le substrat (160, 162).

3. Procédé selon l'une quelconque des revendications précédentes dans lequel la section du deuxième motif (146) présente une forme sensiblement parallélépipédique, un coté du parallélépipède formant la face supérieure (145) sensiblement plane.

4. Procédé selon la revendication précédente prise dans sa combinaison avec la revendication 2, comprenant une étape d'adaptation de l'épaisseur de la deuxième couche (220) en fonction d'un angle supérieur (149) que forme la section du premier motif (144) de manière à ajuster la largeur de la face supérieure (145) sensiblement plane.

5. Procédé selon l'une quelconque des revendications précédentes dans lequel la gravure de la première couche (210) comprend une première gravure anisotrope dirigée perpendiculairement à un plan du substrat (160, 162) pour laisser en place une couche résiduelle sur des flancs du relief (132).

6. Procédé selon l'une quelconque des revendications précédentes dans lequel la gravure de la deuxième couche (220) comprend une première gravure anisotrope dirigée perpendiculairement à un plan du substrat (160, 162) pour laisser en place une couche résiduelle sur le premier motif (144).

7. Procédé selon l'une quelconque des deux revendications précédentes comprenant, après la première gravure anisotrope, une deuxième gravure isotrope sélective avec arrêt de la gravure sur l'empilement de couches (143).

8. Procédé selon l'une quelconque des revendications précédentes dans lequel la formation de la deuxième couche (220) est réalisée de manière à ce que son épaisseur soit constante sur toute la surface déposée.

9. Procédé selon l'une quelconque des revendications précédentes dans lequel l'épaisseur du dépôt de la deuxième couche (220) est comprise entre un quart de et deux fois, et de préférence entre un tiers de et une fois, l'épaisseur du relief (132) en un matériau semi conducteur de la grille (130) du transistor de commande.

10. Procédé selon l'une quelconque des revendications précédentes dans lequel l'épaisseur du dépôt de la première couche (210) est au moins égale au quart de, et de préférence environ égale à, l'épaisseur du relief (132) en un matériau semi conducteur de la grille (130) du transistor de commande.

11. Procédé selon l'une quelconque des revendications précédentes comprenant au moins une séquence d'étapes effectuée à l'issue de la gravure de la deuxième couche (220), chaque séquence comprenant au moins le dépôt d'une couche additionnelle d'un matériau similaire celui de la deuxième couche (220) puis une gravure anisotrope de cette couche additionnelle, le procédé comprenant de préférence au moins deux séquences.

12. Procédé selon l'une quelconque des revendications précédentes dans lequel la formation au moins partielle de la grille (130) du transistor de commande comprend, préalablement du dépôt de la première couche (210), la formation d'une couche sacrificielle (131) au dessus du relief (132) en un matériau semi conducteur, le procédé comprenant également une étape de retrait de la couche sacrificielle (131) effectuée postérieurement à l'étape de gravure de la deuxième couche (220) de sorte à générer une différence de niveau entre la face supérieure (145) du deuxième motif (146) et l'extrémité supérieure du relief (132) en un matériau semi conducteur.

13. Procédé selon l'une quelconque des revendications précédentes dans lequel la grille de contrôle (140) du transistor de mémorisation forme un espaceur pour la grille (130) du transistor de commande.

14. Procédé selon l'une quelconque des revendications précédentes dans lequel la formation de la grille de contrôle (140) du transistor de mémorisation est effectuée de sorte que la grille de contrôle (140) du transistor de mémorisation est auto alignée avec la grille (130) du transistor de commande.

15. Procédé selon l'une quelconque des revendications précédentes dans lequel le matériau semi conducteur de la première couche (210) est du silicium polycristallin et dans lequel le matériau semi conducteur de la deuxième couche (220) est également du silicium polycristallin et dans lequel ledit empilement de couches (143) comprend de préférence deux couches d'isolant électrique (1431, 1433) enserrant une couche intermédiaire (1432) de piégeage de charges.

16. Procédé selon l'une quelconque des revendications précédentes comprenant une étape de recouvrement du deuxième motif (146) par au moins par une couche additionnelle d'oxyde à haute température (330) et de préférence par une couche additionnelle de nitrure de silicium (340) ainsi qu'une étape de retrait partiel de la couche additionnelle au moins de sorte à laisser libre en partie au moins la face supérieure (145) sensiblement plane.

17. Procédé selon l'une quelconque des revendications précédentes comprenant une étape de siliciuration de la face supérieure (145) sensiblement plane.

18. Cellule mémoire non volatile à double grille (100) comprenant un transistor de commande comprenant une grille (130) et un transistor de mémorisation comprenant une grille de contrôle (140) adjacente à la grille (130) du transistor de commande, la grille (130) du transistor de commande comprenant un relief (132) en un matériau semi conducteur et la grille de contrôle (140) du transistor de mémorisation comprenant :
- un empilement de couches (143) juxtaposé à la grille du transistor de commande (140) et configuré pour stocker des charges électriques,
- un premier motif (144) en un matériau semi conducteur disposé sur l'empilement de couches (143) et présentant une section sensiblement triangulaire,
**caractérisée en ce que** la grille de contrôle (140) du transistor de mémorisation comprend en outre un deuxième motif (146) en un matériau semi conducteur disposé sur le premier motif (144) et configuré pour présenter une face supérieure (145) sensiblement plane.

## Patentansprüche

1. Verfahren zur Herstellung einer nicht flüchtigen Speicherzelle mit Dualgate (100), umfassend einen Steuertransistor, der ein Gate (130) umfasst, und einen Speichertransistor, der ein Steuergate (140) umfasst, welches an das Gate (130) des Steuertransistors angrenzt, wobei die Schritte vorgenommen werden des:
∘ mindestens teilweisen Bildens des Gates (130) des Steuertransistors, umfassend das Erhalten einer Erhebung (132) aus einem Halbleitermaterial auf einem Substrat (160, 162);
∘ Bildens des Steuergates (140) des Speichertransistors, umfassend die Schritte des:
- Bildens eines Schichtenstapels (143) auf mindestens einer Flanke der Erhebung (132) aus einem Halbleitermaterial und mindestens einem Teil des Substrats (160, 162), der dafür konfiguriert ist, elektrische Ladungen zu speichern;
- Abscheidens einer ersten Schicht (210) aus einem Halbleitermaterial, um mindestens den Schichtenstapel (143) zu bedecken;
- Ätzens der ersten Schicht (210), um neben der Erhebung (132) aus einem Haltleitermaterial des Gates (130) des Steuertransistors ein erstes Muster (144) zu bilden;
**dadurch gekennzeichnet, dass** das Bilden des Steuergates (140) des Speichertransistors weiter die folgenden Schritte umfasst des:
∘ Bildens einer zweiten Schicht (220) aus einem Halbleitermaterial mindestens auf dem ersten Muster (144),
∘ Ätzens der zweiten Schicht (220) derart, dass auf dem ersten Muster (144) ein zweites Muster (146) gebildet wird, das eine im Wesentlichen ebene obere Seite (145) aufweist, die dafür konfiguriert ist, eine Kontaktierung am Steuergate (140) des Speichertransistors zu ermöglichen.

2. Verfahren nach dem vorstehenden Anspruch, wobei der Querschnitt des ersten Musters (144) im Wesentlichen eine Dreiecksform aufweist, von der aneinandergrenzende Seiten jeweils dem Gate des Steuertransistors und dem Substrat (160, 162) zugewandt sind.

3. Verfahren nach einem der vorstehenden Ansprüche, wobei der Querschnitt des zweiten Musters (146) eine im Wesentlichen parallelepipedische Form aufweist, wobei eine Seite des Parallelepipeds die im Wesentlichen ebene obere Seite (145) bildet.

4. Verfahren nach dem vorstehenden Anspruch in Kombination mit Anspruch 2, das einen Schritt des Anpassens der Dicke der zweiten Schicht (220) in Abhängigkeit von einem oberen Winkel (149), den der Querschnitt des ersten Musters (144) bildet, umfasst, um die Breite der im Wesentlichen ebenen oberen Seite (145) anzupassen.

5. Verfahren nach einem der vorstehenden Ansprüche, wobei das Ätzen der ersten Schicht (210) ein erstes anisotropes Ätzen umfasst, das senkrecht zu einer Ebene des Substrats (160, 162) gerichtet ist, um eine Restschicht auf Flanken der Erhebung (132) zu belassen.

6. Verfahren nach einem der vorstehenden Ansprüche, wobei das Ätzen der zweiten Schicht (220) ein erstes anisotropes Ätzen umfasst, das senkrecht zu einer Ebene des Substrats (160, 162) gerichtet ist, um eine Restschicht auf dem ersten Muster (144) zu belassen.

7. Verfahren nach einem der zwei vorstehenden Ansprüche, das nach dem ersten anisotropen Ätzen ein zweites selektives isotropes Ätzen mit Stoppen des Ätzens am Schichtenstapel (143) umfasst.

8. Verfahren nach einem der vorstehenden Ansprüche, wobei das Bilden der zweiten Schicht (220) so ausgeführt wird, dass ihre Dicke auf der gesamten abgeschiedenen Fläche konstant ist.

9. Verfahren nach einem der vorstehenden Ansprüche, wobei die Dicke der Abscheidung der zweiten Schicht (220) im Bereich zwischen einem Viertel und dem Zweifachen, und vorzugsweise zwischen einem Drittel und dem Einfachen der Dicke der Erhebung (132) aus einem Halbleitermaterial des Gates (130) des Steuertransistors liegt.

10. Verfahren nach einem der vorstehenden Ansprüche, wobei die Dicke der Abscheidung der ersten Schicht (210) mindestens gleich einem Viertel, und vorzuweise etwa gleich der Dicke der Erhebung (132) aus einem Haltleitermaterial des Gates (130) des Steuertransistors ist.

11. Verfahren nach einem der vorstehenden Ansprüche, das mindestens eine Abfolge von Schritte umfasst, die am Ende des Ätzens der zweiten Schicht (220) vorgenommen wird, wobei jede Abfolge mindestens das Abscheiden einer zusätzlichen Schicht eines Materials, das demjenigen der zweiten Schicht (220) ähnlich ist, und anschließend ein anisotropes Ätzen dieser zusätzlichen Schicht umfasst, wobei das Verfahren vorzugsweise mindestens zwei Abfolgen umfasst.

12. Verfahren nach einem der vorstehenden Ansprüche, wobei das mindestens teilweise Bilden des Gates (130) des Steuertransistors vor dem Abscheiden der ersten Schicht (210) das Bilden einer Opferschicht (131) über der Erhebung (132) aus einem Halbleitermaterial umfasst, wobei das Verfahren ebenfalls einen Schritt des Entfernens der Opferschicht (131) umfasst, der nach dem Schritt des Ätzens der zweiten Schicht (220) derart vorgenommen wird, dass ein Niveauunterschied zwischen der oberen Seite (145) des zweiten Musters (146) und dem oberen Ende der Erhebung (132) aus einem Halbleitermaterial erzwugt wird.

13. Verfahren nach einem der vorstehenden Ansprüche, wobei das Steuergate (140) des Speichertransistors einen Abstandshalter für das Gate (130) des Steuertransistors bildet.

14. Verfahren nach einem der vorstehenden Ansprüche, wobei das Bilden des Steuergates (140) des Speichertransistors derart vorgenommen wird, dass das Steuergate (140) des Speichertransistors selbständig zum Gate (130) des Steuertransistors ausgerichtet wird.

15. Verfahren nach einem der vorstehenden Ansprüche, wobei das Halbleitermaterial der ersten Schicht (210) polykristallines Silizium ist, und wobei das Halbleitermaterial der zweiten Schicht (220) ebenfalls polykristallines Silizium ist, und wobei der Schichtenstapel (143) vorzugsweise zwei Schichten eines elektrischen Isolators (1431, 1433) umfasst, die eine Ladungsfänger-Zwischenschicht (1432) umschließen.

16. Verfahren nach einem der vorstehenden Ansprüche, das einen Schritt des Bedeckens des zweiten Musters (146) mit mindestens mit einer zusätzlichen Hochtemperaturoxidschicht (330) und vorzugsweise mit einer zusätzlichen Siliziumnitridschicht (340), sowie einen Schritt des mindestens teilweisen Entfernens der zusätzlichen Schicht derart umfasst, dass die im Wesentlichen ebene obere Seite (145) mindestens zum Teil frei gelassen wird.

17. Verfahren nach einem der vorstehenden Ansprüche, das einen Schritt des Silizierens der im Wesentlichen ebenen oberen Seite (145) umfasst.

18. Nicht flüchtige Speicherzelle mit Dualgate (100), das einen Steuertransistor, der ein Gate (130) umfasst, und einen Speichertransistor umfasst, der ein Steuergate (140) umfasst, das an das Gate (130) des Steuertransistors angrenzt, wobei das Gate (130) des Steuertransistors eine Erhebung (132) aus einem Halbleitermaterial umfasst, und das Steuergate (140) des Speichertransistors umfasst:
- einen Schichtenstapel (143) neben dem Gate des Steuertransistors (140) und dafür konfiguriert, elektrische Ladungen zu speichern,
- ein erstes Muster (144) aus einem Halbleitermaterial, das auf dem Schichtenstapel (143) angeordnet ist und einen im Wesentlichen dreieckigen Querschnitt aufweist,
**dadurch gekennzeichnet, dass** das Steuergate (140) des Speichertransistors weiter ein zweites Muster (146) aus einem Halbleitermaterial umfasst, das auf dem ersten Muster (144) angeordnet und dafür konfiguriert ist, eine im Wesentlichen ebene obere Seite (145) aufzuweisen.

## Claims

1. Method for producing a double-gate non-volatile memory cell (100) comprising a driver transistor comprising a gate (130) and a memory transistor comprising a control gate (140) adjacent to the gate (130) of the driver transistor, wherein the following steps are carried out:
∘ forming at least partially the gate (130) of the driver transistor comprising the obtaining of a relief (132) made of a semi-conductive material on a substrate (160, 162);
∘ forming the control gate (140) of the memory transistor, comprising steps of:
- forming on at least one edge of the relief (132) made of a semi-conductive material and at least one portion of the substrate (160, 162) of a stack of layers (143) configured to store electrical charges;
- deposition of a first layer (210) of a semi-conductive material so as to cover the stack of layers (143) at least;
- etching of the first layer (210) so as to form a first pattern (144) juxtaposed to the relief (132) made of a semi-conductive material of the gate (130) of the driver transistor;
**characterised in that** the formation of the control gate (140) of the memory transistor further comprises following steps of:
∘ forming a second layer (220) of a semi-conductive material at least on the first pattern (144),
∘ etching of the second layer (220) so as to form on the first pattern (144), a second pattern (146) having an upper face (145), substantially flat, configured to make it possible for a re-contact on the control gate (140) of the memory transistor.

2. Method according to the preceding claim, wherein the cross-section of the first pattern (144) substantially has a triangular shape of which two adjacent sides are respectively rotated towards the gate of the driver transistor and towards the substrate (160, 162).

3. Method according to any one of the preceding claims, wherein the cross-section of the second pattern (146) has a substantially parallelepiped shape, one side of the parallelepiped forming the substantially flat upper face (145).

4. Method according to the preceding claim, taken combined with claim 2, comprising a step of adapting the thickness of the second layer (220) according to an upper angle (149) that forms the cross-section of the first pattern (144) so as to adjust the width of the substantially flat upper face (145).

5. Method according to any one of the preceding claims, wherein the etching of the first layer (210) comprises a first anisotropic etching directly perpendicularly to a plane of the substrate (160, 162) to leave in place a residual layer on the edges of the relief (132).

6. Method according to any one of the preceding claims, wherein the etching of the second layer (220) comprises a first anisotropic etching directly perpendicularly to a plane of the substrate (160, 162) to leave in place a residual layer on the first pattern (144).

7. Method according to any one of the two preceding claims comprising, after the first anisotropic etching, a second selective isotropic etching with stopping of the etching on the stack of layers (143).

8. Method according to any one of the preceding claims, wherein the formation of the second layer (220) is carried out such that the thickness thereof is constant over the whole deposited surface.

9. Method according to any one of the preceding claims, wherein the thickness of the deposition of the second layer (220) is of between one quarter of a time and twice, and preferably between one third and once, the thickness of the relief (132) made of a semi-conductive material of the gate (130) of the driver transistor.

10. Method according to any one of the preceding claims, wherein the thickness of the deposition of the first layer (210) is at least equal to the quarter of, and preferably around equal to the thickness of the relief (132) made of a semi-conductive material of the gate (130) of the driver transistor.

11. Method according to any one of the preceding claims, comprising at least one sequence of steps carried out from the etching of the second layer (220), each sequence comprising at least the deposition of an additional layer of a material similar to that of the second layer (220), then an anisotropic etching of this additional layer, the method preferably comprising at least two sequences.

12. Method according to any one of the preceding claims, wherein the at least partial formation of the gate (130) of the driver transistor comprises, prior to the deposition of the first layer (210), the formation of a sacrificial layer (131) above the relief (132) made of a semi-conductive material, the method also comprising a step of removing the sacrificial layer (131) carried out prior to the step of etching the second layer (220) so as to generate a different in level between the upper face (145) of the second pattern (146) and the upper end of the relief (132) made of a semi-conductive material.

13. Method according to any one of the preceding claims, wherein the control gate (140) of the memory transistor forms a spacer for the gate (130) of the driver transistor.

14. Method according to any one of the preceding claims, wherein the formation of the control gate (140) of the memory transistor is carried out such that the control gate (140) of the memory transistor is self-aligned with the gate (130) of the driver transistor.

15. Method according to any one of the preceding claims, wherein the semi-conductive material of the first layer (210) is of polycrystalline silicon and wherein the semi-conductive material of the second layer (220) is also of polycrystalline silicon and wherein said stack of layers (143) preferably comprises two electrical insulator layers (1431, 1433) surrounding an intermediate charge capture layer (1432).

16. Method according to any one of the preceding claims, comprising a step of covering the second pattern (146) at least by an additional, high-temperature oxide layer (330) and preferably by an additional silicon nitride layer (340), as well as a step of partially removing the additional layer at least so as to leave partially free at least the substantially flat upper face (145).

17. Method according to any one of the preceding claims, comprising a step of silicifying the substantially flat upper face (145).

18. Double-gate non-volatile memory cell (100) comprising a driver transistor comprising a gate (130) and a memory transistor comprising a control gate (140) adjacent to the gate (130) of the driver transistor, the gate (130) of the driver transistor comprising a relief (132) made of a semi-conductive material and the control gate (140) of the memory transistor comprising:
- a stack of layers (143) juxtaposed to the gate of the driver transistor (140) and configured to store electrical charges,
- a first pattern (144) made of a semi-conductive material arranged on the stack of layers (143) and having a substantially triangular cross-section,
**characterised in that** the control gate (140) of the memory transistor further comprises a second pattern (146) made of a semi-conductive material arranged on the first pattern (144) and configured to have a substantially flat upper face (145).
